# EUROPÄISCHE PATENTANMELDUNG

(11) **EP 3 024 312 A2**
(43) Veröffentlichungstag der Anmeldung: **25.05.2016**
(21) Anmeldenummer: 15186479.0
(22) Anmeldetag: 23.09.2015
(51) Int. Cl.: H05K 13/00

(54) **VERFAHREN ZUM BESTÜCKEN VON LEITERPLATTEN**

(30) Priorität: 18.11.2014 DE 102014116879
(71) Anmelder: ASM Assembly Systems GmbH & Co. KG, 81379 München (DE)
(72) Erfinder: HEUBERGER, Franz, 69126 Heidelberg (DE); KIENER, Rudolf, 82538 Geretsried (DE); MEISSNER, Christian, 83043 Bad Aibling (DE)
(74) Vertreter: Patentanwälte Bals & Vogel

(57) **Zusammenfassung**

Die vorliegende Erfindung betrifft eine Verfahren zum Bestücken von Leiterplatten auf einer Bestückungsmaschine, wobei die Leiterplatten eine erste Länge aufweisen und die Bestückungsmaschine zum Bestücken von Leiterplatten einer zweiten Länge ausgebildet ist, wobei die zweite Länge mehr als doppelt so groß wie die erste Länge ist. Die Bestückungsmaschine weist eine Eingabesektion (1) und eine Bestückungssektion (2) auf, wobei die Bestückungssektion (2) in einer Förderrichtung (F) der Leiterplatten hinter der Eingabesektion (1) angeordnet in einer Förderrichtung der Leiterplatten hinter der Eingabesektion (1) angeordnet ist, wobei die Leiterplatten der ersten Länge und die Leiterplatten der zweiten Länge in ihrer Längsrichtung von der Eingabesektion (1) in die Bestückungsstation (2) transportierbar sind. Gemäß dem Verfahren werden erste Leiterplatten (5) der ersten Länge in einem Pufferbereich (6) der Bestückungssektion (2) zwischengepuffert und weisen somit einen verkürzten Transportweg zu einer Bestückungsstelle (4) der Bestückungssektion (2) als von der Eingabesektion (1) auf.

## Beschreibung

Die vorliegende Erfindung betrifft ein Verfahren zum Bestücken von Leiterplatten einer ersten Länge auf einer Bestückungsmaschine, wobei die Bestückungsmaschine zum Bestücken von Leiterplatten einer zweiten Länge ausgebildet ist. Dabei ist die zweite Länge mehr als doppelt so groß wie die erste Länge. Die Bestückungsmaschine weist eine Eingabesektion und eine Bestückungsstation auf, wobei die Bestückungsstation in einer Förderrichtung der Leiterplatten hinter der Eingabesektion angeordnet ist. Die Leiterplatten der ersten Länge und die Leiterplatten der zweiten Länge sind in ihrer Längsrichtung von der Eingabesektion in Förderrichtung in die Bestückungsstation transportierbar.

Es ist bekannt, dass Leiterplatten auf einer Bestückungsmaschine mit elektronischen Komponenten, wie z.B. Widerständen, Kondensatoren, Dioden, bestückt werden. Herkömmliche Bestückungsmaschinen weisen hierfür eine Fördereinrichtung auf, mit der eine Leiterplatte entlang ihrer Längsrichtung von einer Eingabesektion an eine Bestückungsstelle einer Bestückungssektion transportierbar ist. An der Bestückungsstelle wird die Leiterplatte zum Bestücken genau positioniert und zumindest für die Dauer der Bestückung temporär fixiert. Beim Bestücken werden aus einem Vorrat bereitgestellte elektronische Komponenten von einer Bestückungseinheit aus dem Vorrat entnommen und auf der Leiterplatte angeordnet. Nach dem Vorgang des Bestückens wird die Fixierung der Leiterplatte aufgehoben, die Leiterplatte aus der Bestückungssektion heraustransportiert und eine folgende Leiterplatte von der Eingabesektion an die Bestückungsstelle transportiert. Die Zeit, die der Transport dieser unbestückten Leiterplatte zur Bestückungsstelle erfordert, wird auch als Wechselzeit bezeichnet.

In einem Folgeprozess nach dem Bestücken werden die elektronischen Komponenten z.B. durch Löten an der Leiterplatte derart fixiert, dass die elektronische Komponente mit der Leiterplatte elektrisch verbunden ist. Herkömmliche Bestückungsmaschinen sind zur Bestückung unterschiedlicher Leiterplatten mit unterschiedlichen Abmessungen, wie z.B. Breite und/oder Länge, ausgebildet. Eine maximale Länge einer auf einer Bestückungsmaschine bestückbaren Leiterplatte ist dabei durch eine Länge der Eingabesektion sowie der Bestückungssektion der Bestückungsmaschine festgelegt. Bei Leiterplatten, die eine Länge aufweisen, die weniger als die Hälfte der maximalen Länge auf der Bestückungsmaschine bestückbaren Leiterplatte beträgt, besteht das Problem, dass nach dem Abtransport der bestückten Leiterplatte für die nächste zu bestückende Leiterplatte ein Transportweg zwischen der Eingangssektion und der Bestückungsstelle zu überwinden ist, der mindestens das Doppelte der Länge der entsprechenden Leiterplatte beträgt, wobei der Transportweg im Idealfall der Länge der Leiterplatte entspricht. Wegen dieses im Verhältnis zur Länge der Leiterplatte relativ langen Transportwegs ist die Wechselzeit der Leiterplatten höher als im Idealfall. Hierdurch wird die Fertigungskapazität der Bestückungsmaschine deutlich reduziert.

Aus der EP Patentanmeldung 1 863 330 ist eine Bestückungsmaschine mit einem Transportsystem bekannt, das zur Aufnahme sowie Zwischenspeicherung einer Gruppe von Leiterplatten auf einer Speichereinrichtung ausgebildet ist. Eine mit einer Gruppe Leiterplatten beladene Speichereinrichtung ist in einen Bestückungsbereich der Bestückungsmaschine zur Bestückung verfahrbar. Ein derartiges Transportsystem hat den Nachteil, dass es nur mit großen Investitionskosten in eine herkömmliche Bestückungsmaschine implementierbar ist. Des Weiteren ist eine Bestückungseinrichtung der Bestückungsmaschine für die Dauer der Aufnahme der einzelnen Leiterplatten auf der Speichereinrichtung inaktiv, so dass hierdurch relativ lange Totzeiten zwischen einer Fertigstellung der Bestückung von Leiterplatten einer Gruppe und dem Anfang der Bestückung von Leiterplatten einer folgenden Gruppe entstehen.

Aus dem EP Patent 1 535 502 ist eine Bestückungsmaschine für Leiterplatten mit einem Transportsystem bekannt. Die Bestückungsmaschine weist eine Eingabesektion, eine Bestückungssektion und eine Ausgabesektion auf. Über eine Sensoranordnung soll sichergestellt werden, dass ein Transport einer gerade bestückten Leiterplatte von der Bestückungssektion in die Ausgabesektion gleichzeitig mit einem Transport einer unbestückten Leiterplatte von der Eingabesektion in die Bestückungssektion erfolgt. Die EP 1 535 502 behandelt nicht das Problem, wie Leiterplatten unterschiedlicher Länge innerhalb der Bestückungsmaschine zu transportieren sind. Des Weiteren erfordert eine derartige Bestückungsmaschine eine Vielzahl von zusätzlichen Sensoren, so dass ein Nachrüsten einer herkömmlichen Bestückungsmaschine mit diesen Sensoren hohe Investitionskosten erfordert.

Es ist daher Aufgabe der vorliegenden Erfindung, die voranstehend beschriebenen Nachteile bekannter Bestückungsmaschine zumindest teilweise zu beheben. Insbesondere ist es Aufgabe der vorliegenden Erfindung, einen Verfahren zum Bestücken von Leiterplatten einer ersten Länge auf einer Bestückungsmaschine zur Bestückung von Leiterplatten einer zweiten Länge, wobei die erste Länge weniger als die Hälfte der zweiten Länge beträgt, bereitzustellen, das im Vergleich zu herkömmlichen Verfahren geringere Wechselzeiten der Leiterplatten aufweist.

Voranstehende Aufgabe wird gelöst durch ein Verfahren mit den Merkmalen des Anspruchs 1. Weitere Merkmale und Details der Erfindung ergeben sich aus den Unteransprüchen, der Beschreibung und den Zeichnungen.

Gemäß einem ersten Aspekt der Erfindung wird die Aufgabe gelöst durch ein Verfahren zum Bestücken von Leiterplatten auf einer Bestückungsmaschine, wobei die Leiterplatten eine erste Länge aufweisen und die Bestückungsmaschine zum Bestücken von Leiterplatten einer zweiten Länge ausgebildet ist, wobei die zweite Länge mehr als doppelt so groß wie die erste Länge ist. Die Bestückungsmaschine weist eine Eingabesektion und eine Bestückungssektion auf, wobei die Bestückungssektion in einer Förderrichtung der Leiterplatten hinter der Eingabesektion angeordnet ist, wobei die Leiterplatten der ersten Länge und die Leiterplatten der zweiten Länge in ihrer Längsrichtung von der Eingabesektion in die Bestückungsstation transportierbar sind. Das Verfahren weist die nachfolgenden Verfahrensschritte auf:
- Transportieren einer ersten Leiterplatte erster Länge aus der Eingabesektion in die Bestückungssektion;
- Anordnen der ersten Leiterplatte auf einer Bestückungsstelle der Bestückungssektion;
- Transportieren mindestens einer zweiten Leiterplatte erster Länge aus der Eingabesektion in einen Pufferbereich der Bestückungssektion, wobei der Pufferbereich zwischen der Bestückungsstelle und der Eingabesektion angeordnet ist;
- lösbares Fixieren der ersten Leiterplatte an der Bestückungsstelle;
- Bestücken der ersten Leiterplatte;
- Lösen der Fixierung der ersten Leiterplatte
- Transportieren der ersten Leiterplatte aus der Bestückungssektion heraus; und
- Transportieren einer zweiten Leiterplatte, die der Bestückungsstelle benachbart angeordnet ist, aus dem Pufferbereich auf die Bestückungsstelle.

In dem Verfahren verwendete Leiterplatten weisen eine Länge, eine Breite und eine Dicke auf, wobei sich die Länge der Leiterplatten definitionsgemäß parallel zu einer Transportrichtung der Leiterplatten erstreckt. Die erste Leiterplatte und die zweiten Leiterplatten sind vorzugsweise identisch ausgebildet. Eine Unterscheidung zwischen erster Leiterplatte und zweiten Leiterplatten dient lediglich einem besseren Verständnis der Erfindung.

Zur Ausführung des erfindungsgemäßen Verfahrens ist mindestens eine Bestückungsmaschine bzw. ein Bestückungsautomat erforderlich, der zur Bestückung von Leiterplatten einer zweiten Länge ausgebildet ist. Die zweite Länge ist eine Länge, die eine Leiterplatte maximal aufweisen kann, um von der Bestückungsmaschine bestückbar zu sein. Die zweite Länge wird im Wesentlichen durch eine Länge der Bestückungssektion bestimmt.

Des Weiteren sind zur Ausführung des erfindungsgemäßen Verfahrens Leiterplatten erforderlich, die eine erste Länge aufweisen, wobei die erste Länge weniger als die Hälfte der zweiten Länge beträgt, so dass anstatt einer Leiterplatte der zweiten Länge mindestens zwei Leiterplatten der ersten Länge in der Bestückungssektion voneinander beabstandet angeordnet werden können.

Eine Eingabesektion ist ein Bereich der Bestückungsmaschine, in dem zu bestückende Leiterplatten bereitstellbar sind. Die Eingabesektion ist neben der Bestückungssektion angeordnet, so dass eine Leiterplatte von der Eingabesektion in die Bestückungsstation in Transportrichtung und somit in Richtung der Länge der Leiterplatte transportierbar ist.

Beim Transportieren der ersten Leiterplatte erster Länge aus der Eingabesektion in die Bestückungssektion wird die erste Leiterplatte von einer Transporteinrichtung in Transportrichtung bewegt und durchläuft hierbei den Pufferbereich.

In einem folgenden Schritt wird die erste Leiterplatte an der Bestückungsstelle der Bestückungsstation angeordnet. Die Bestückungsstelle ist die Stelle an der die Leiterplatte während des Bestückens angeordnet ist. Beim Anordnen der Leiterplatte an der Bestückungsstelle erfolgt vorzugsweise ein genaues Positionieren der Leiterplatte zur Bestückungsmaschine, so dass die Bestückungseinrichtung der Bestückungsmaschine die elektronischen Komponenten exakt und ohne das Erfordernis einer aufwändigen Sensorik auf der Leiterplatte anordnen kann.

Das Transportieren der mindestens einen zweiten Leiterplatte erster Länge aus der Eingabesektion in den Pufferbereich erfolgt vorzugsweise simultan mit dem Transportieren der ersten Leiterplatte erster Länge aus dem Pufferbereich in die Bestückungssektion.

Der Pufferbereich ist ein Bereich der Bestückungssektion, in dem bei Leiterplatten der ersten Länge keine Bestückung erfolgt. Bei der Bestückung von Leiterplatten zweiter Länge ist demnach kein Pufferbereich vorhanden, da sich derartige Leiterplatten im Wesentlichen über die gesamte Länge der Bestückungssektion erstrecken.

Beim lösbaren Fixieren der ersten Leiterplatte an der Bestückungsstelle wird die vorzugsweise genau positionierte Leiterplatte z.B. über eine Klemmvorrichtung relativ zur Bestückungsmaschine fixiert, um eine Relativbewegung der Leiterplatte zur Bestückungsmaschine und eine damit verbundene Lageänderung der Leiterplatte relativ zur Bestückungsmaschine während des Bestückens zu verhindern. Eine derartige Lageänderung kann z.B. eine fehlerhafte Bestückung und/oder eine Beschädigung von Leiterplatte und/oder der elektronischen Komponenten zur Folge haben. Alternativ kann die erste Leiterplatte auch während des Transports an der Transportvorrichtung lösbar fixiert sein, wobei die Transportvorrichtung relativ zur übrigen Bestückungsmaschine feststellbar ist, so dass ein weiteres Fixieren an der Bestückungsstelle sowie ein Lösen der Leiterplatte nach dem Bestücken und vor dem Weitertransport in dieser Alternative nicht erforderlich ist.

Beim Transportieren der ersten Leiterplatte aus der Bestückungssektion heraus wird die erste Leiterplatte von der Transporteinrichtung in Transportrichtung bewegt.

Das Transportieren der zweiten Leiterplatte aus dem Pufferbereich an die Bestückungsstelle erfolgt vorzugsweise gleichzeitig mit dem Transportieren der ersten Leiterplatte aus der Bestückungssektion heraus. Auf diese Weise wird die Wechselzeit weiter optimiert.

Das erfindungsgemäße Verfahren zur Bestückung von Leiterplatten erster Länge hat gegenüber bekannten Verfahren den Vorteil, dass die Wechselzeit einer herkömmlichen Bestückungsmaschine, die für Leiterplatten zweiter Länge ausgebildet ist, deutlich reduzierbar ist, da nach dem Bestücken einer ersten Leiterplatte eine zweite Leiterplatte bereits neben der Bestückungsstelle angeordnet ist und somit nur einen kurzen Weg zur Bestückungsstelle transportiert werden muss. Durch diese Zeitersparnis kann die Fertigungskapazität einer herkömmlichen Bestückungsmaschine ohne großen Aufwand, wie z.B. Umbaumaßnahmen an der Bestückungsmaschine sowie damit verbundene Investitionskosten, erhöht werden.

Vorzugsweise wird eine maximale Anzahl an in dem Pufferbereich anordenbaren zweiten Leiterplatten in Abhängigkeit der ersten Länge der zweiten Leiterplatten, einer Länge des Pufferbereichs sowie einem festgelegten Abstand zwischen in dem Pufferbereich benachbarten zweiten Leiterplatten bestimmt, und dass nur so viele zweite Leiterplatten in den Pufferbereich transportiert werden, dass diese maximale Anzahl nicht überschritten wird. Dies hat den Vorteil, dass es innerhalb der Bestückungssektion nicht zu einer Kollision von Leiterplatten kommen kann.

Ferner kann bei einem erfindungsgemäßen Verfahren vorgesehen sein, dass eine Soll-Bestückungsleistung der Bestückungsmaschine sowie eine Anzahl an in den Pufferbereich zu verfahrenden zweiten Leiterplatten in Abhängigkeit der Soll-Bestückungsleistung der Bestückungsmaschine und der maximalen Anzahl an in dem Pufferbereich anordenbaren zweiten Leiterplatten bestimmt wird, und dass eine entsprechende Anzahl zweiter Leiterplatten aus der Eingabesektion in den Pufferbereich der Bestückungssektion transportiert wird. Eine Soll-Bestückungsleistung der Bestückungsmaschine ist eine Zielgröße der Fertigungskapazität der Bestückungsmaschine. Die Soll-Bestückungsleistung ergibt sich beispielsweise aus einer Fertigungsleistung weiterer Vorrichtungen bzw. Maschinen, die mit der Bestückungsmaschine in einer Fertigungsreihe angeordnet sind. Somit wird vorteilhaft erreicht, dass ein Transport von zweiten Leiterplatten in den Pufferbereich nur in Abhängigkeit eines tatsächlichen Bedarfs einer Fertigungskapazitätssteigerung der Bestückungsmaschine erfolgt.

Vorzugsweise wird mindestens eine der zweiten Leiterplatten in dem Pufferbereich lösbar fixiert. Somit ist die zweite Leiterplatte während des Bestückens der ersten Leiterplatte gegen eine Lageänderung gesichert. Hierfür weist die Bestückungssektion eine Fixiervorrichtung, wie z.B. eine Klemmvorrichtung auf, die zur gleichzeitigen Fixierung von in der Bestückungssektion angeordneten Leiterplatten ausgebildet ist.

Weiter bevorzugt wird mindestens eine in den Pufferbereich transportierte zweite Leiterplatte innerhalb des Pufferbereichs vor dem Transportieren in die Bestückungsstelle ausgerichtet. Hierdurch wird ein anschließendes Anordnen der zweiten Leiterplatte in der Bestückungsstelle erleichtert bzw. optimiert. Dies kann zu einer Zeitersparnis und somit zu einer Erhöhung der Fertigungskapazität der Bestückungsmaschine führen. Unter Ausrichten wird im Sinne der Erfindung auch ein Anfahren einer konkreten Position verstanden.

Es ist bevorzugt, dass die Bestückungsstelle an einem von der Eingabesektion abgewandten Ende der Bestückungssektion angeordnet ist. Somit weist ein Pufferbereich eine maximale Größe auf. Überdies weist somit ein Transportweg von der Bestückungsstelle zu einer Ausgabe der Bestückungsmaschine eine minimale Länge auf, so dass eine bestückte zweite Leiterplatte schnell aus der Bestückungssektion heraustransportierbar ist.

Gemäß einer bevorzugten Weiterentwicklung eines erfindungsgemäßen Verfahrens wird die bestückte erste Leiterplatte aus der Bestückungssektion in eine Ausgabesektion transportiert. Die Ausgabesektion ist vorzugsweise ein Teil der Bestückungsmaschine und ist zum Sammeln bzw. Puffern bestückter Leiterplatten ausgebildet.

Es ist vorteilhaft, wenn die zweiten Leiterplatten im Pufferbereich voneinander beabstandet angeordnet werden. Auf diese Weise wird eine Kollision benachbarter Leiterplatten vermieden und somit eine Prozesssicherheit der Bestückungsmaschine weiter erhöht.

Vorzugsweise wird eine Anwesenheit und/oder Lage der ersten Leiterplatte und/oder mindestens einer zweiten Leiterplatte in der Bestückungssektion überwacht und bei Fehlen bzw. einer falschen Lage einer ersten Leiterplatte und/oder zweiten Leiterplatte eine entsprechende erste Leiterplatte und/oder zweite Leiterplatte in die entsprechende Stelle in der Bestückungsstation transportiert bzw. die Lage der jeweiligen ersten Leiterplatte und/oder zweiten Leiterplatte korrigiert. Eine derartige Überwachung wird vorzugsweise mit einem Sensor, insbesondere einem optischen Sensor, durchgeführt, so dass die Überwachung automatisierbar ist. Dies hat den Vorteil, dass ein Fehler, wie z.B. das Fehlen oder eine falsche Lage einer Leiterplatte automatisch behebbar ist, ohne dass es hierdurch zwangsläufig zu einer Produktionsverzögerung kommt.

Besonders bevorzugt wird beim Anordnen der ersten Leiterplatte an der Bestückungsstelle die erste Leiterplatte in einen Wirkbereich mindestens einer Ausrichteinrichtung gefördert. Eine Ausrichteinrichtung weist z.B. einen Anschlagspunkt für die Leiterplatte auf, gegen den die Leiterplatte verfahrbar ist. Demnach ist die Ausrichteinrichtung vorzugsweise als Stoppeinrichtung ausgebildet. Die Ausrichteinrichtung kann auch einen Sensor, wie z.B. eine Lichtschranke, aufweisen, über den eine Leiterplatte detektierbar und ein entsprechendes Signal an eine Steuereinheit übermittelbar ist. Die Steuereinheit ist vorzugsweise derart konfiguriert, beim Erhalten eines derartigen Sensorsignals den Transport der erfassten Leiterplatte zu stoppen.

Weitere Vorteile, Merkmale und Einzelheiten der Erfindung ergeben sich aus der nachfolgenden Beschreibung, in der unter Bezugnahme auf die Zeichen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Elemente mit gleicher Funktion und Wirkungsweise sind in den einzelnen Figuren mit denselben Bezugszeichen versehen. Es zeigen schematisch:
- Fig. 1: einen Ausschnitt eines Transportsystems einer Bestückungsmaschine nach dem Stand der Technik zu einem zweiten Zeitpunkt;
- Fig. 2: ein Ablaufdiagramm des erfindungsgemäßen Verfahrens,
- Fig. 3: einen Ausschnitt eines Transportsystems einer Bestückungsmaschine gemäß der Erfindung zu einem ersten Zeitpunkt,
- Fig. 4: den Ausschnitt aus Fig. 3 zu einem zweiten Zeitpunkt;
- Fig. 5: den Ausschnitt aus Fig. 3 zu einem dritten Zeitpunkt; und
- Fig. 6: den Ausschnitt aus Fig. 3 zu einem vierten Zeitpunkt.

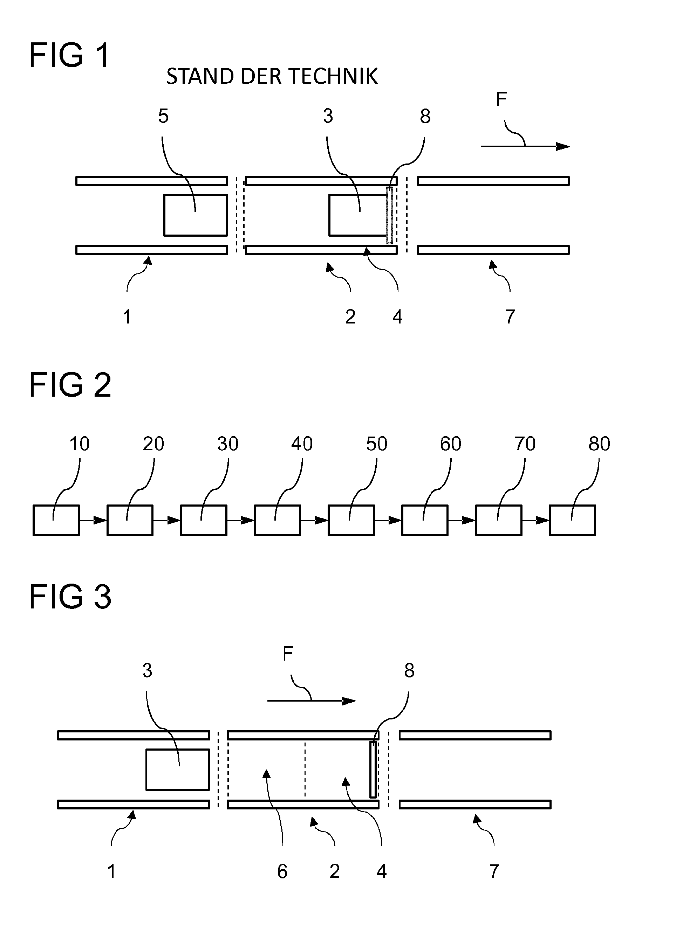

Fig. 1 zeigt schematisch einen Ausschnitt eines Transportsystems nach dem Stand der Technik zu einem zweiten Zeitpunkt. Das Transportsystem der Bestückungsmaschine weist drei Sektionen auf, nämlich eine Eingabesektion 1, eine Bestückungssektion 2 und eine Ausgabesektion 7, wobei die Bestückungssektion 2 zwischen Eingabesektion 1 und Ausgabesektion 7 angeordnet ist. Die Bestückungsstation 2 weist eine der Ausgabesektion 7 benachbarte Bestückungsstelle 4 auf.

Zu dem zweiten Zeitpunkt ist die erste Leiterplatte 3 an der Bestückungsstelle 4 angeordnet und zur Bestückung mittels einer Ausrichteinrichtung 8 positioniert sowie in dieser Lage an der Bestückungsmaschine temporär fixiert. Die Ausrichteinrichtung 8 ist in diesem Ausführungsbeispiel relativ zum Transportsystem verfahrbar bzw. verschwenkbar, um einen Weitertransport einer bestückten ersten Leiterplatte 3 in die Ausgabesektion 7 nicht zu behindern. In einer alternativen Ausführungsform kann die Ausrichteinrichtung auch im Wesentlichen starr ausgebildet sein.

Eine der ersten Leiterplatte 3 folgende zweite Leiterplatte 5 ist in die Eingabesekion 1 in Förderrichtung F hinter der ersten Leiterplatte 3 angeordnet. Erst nach dem Bestücken und beim Weitertransport der ersten Leiterplatte 3 in die Ausgabesektion 7 wird die zweite Leiterplatte 5 auf die Bestückungsstelle 4 transportiert. Dieser Transportweg ist im Verhältnis zur Länge der zweiten Leiterplatte 5 relativ lang, so dass der Transport eine entsprechend lange Zeit in Anspruch nimmt und die Produktivität der Bestückungsmaschine herabsetzt.

Fig. 2 zeigt schematisch in einem Ablaufdiagramm das erfindungsgemäße Verfahren. Im ersten Verfahrensschritt 10 wird eine erste Leiterplatte 3 erster Länge aus einer Eingabesektion 1 in eine Bestückungssektion 2 transportiert. Im zweiten Verfahrensschritt 20 wird die erste Leiterplatte 3 an einer Bestückungsstelle 4 der Bestückungssektion 2 angeordnet. Im dritten Verfahrensschritt 30 wird mindestens eine zweite Leiterplatte 5 erster Länge aus der Eingabesektion 1 in einen Pufferbereich 6 der Bestückungssektion 2 transportiert. Der Pufferbereich ist zwischen der Bestückungsstelle 4 und der Eingabesektion 1 angeordnet. Im vierten Verfahrensschritt 40 wird die erste Leiterplatte 3 lösbar an der Bestückungsstelle 4 fixiert. Im fünften Verfahrensschritt 50 wird die erste Leiterplatte 3 mit mindestens einer Elektronikkomponente 9 bestückt. Im sechsten Verfahrensschritt 60 wird die Fixierung der ersten Leiterplatte 3 gelöst. Im siebten Verfahrensschritt 70 wird die erste Leiterplatte 3 aus der Bestückungssektion 2 heraus transportiert. Im achten Verfahrensschritt 80 wird die zweite Leiterplatte 5, die der Bestückungsstelle 4 benachbart angeordnet ist, aus dem Pufferbereich 6 auf die Bestückungsstelle 4 transportiert.

Fig. 3 zeigt einen Ausschnitt eines Transportsystems einer Bestückungsmaschine zu einem ersten Zeitpunkt. Das Transportsystem der Bestückungsmaschine weist drei Sektionen auf, nämlich eine Eingabesektion 1, eine Bestückungssektion 2 und eine Ausgabesektion 7, wobei die Bestückungssektion 2 zwischen Eingabesektion 1 und Ausgabesektion 7 angeordnet ist. Die Bestückungsstation 2 weist eine der Ausgabesektion 7 benachbarte Bestückungsstelle 4 sowie einen der Eingabesektion 1 benachbarten Pufferbereich 6 auf. In der Bestückungssektion 2 ist eine Ausrichteinrichtung 8 angeordnet, die als Sensor ausgebildet ist. Über den Sensor ist ermittelbar, wenn eine Leiterplatte in der Bestückungsstelle 4 angeordnet ist, damit die Leiterplatte an dieser Position angehalten werden kann. In dieser Darstellung sind die einzelnen Sektionen nur schematisch sowie voneinander beabstandet dargestellt. Es ist bevorzugt, dass die Sektionen in einer Reihe direkt aneinandergrenzend angeordnet sind.

Zu dem ersten Zeitpunkt ist eine erste Leiterplatte 3 in der Eingabesektion 1 sowie der Bestückungssektion 2 benachbart angeordnet. Die erste Leiterplatte 3 ist auf einer nicht dargestellten Transporteinrichtung angeordnet und mittels dieser in Förderrichtung F, also von der Eingabesektion 1 in Richtung der Bestückungssektion 2, verfahrbar. Der Zustand des ersten Zeitpunkts ist ein initialer Zustand, der z.B. bei der Inbetriebnahme der Bestückungsmaschine vorkommt. Eine weitere Möglichkeit eines initialen Zustand ist z.B. beim Einfahren eines neuen Produkts in die Bestückungsmaschine. Im weiteren Betrieb der Bestückungsmaschine befindet sich i.d.R. mindestens eine zweite Leiterplatte 5 in der Bestückungssektion 2.

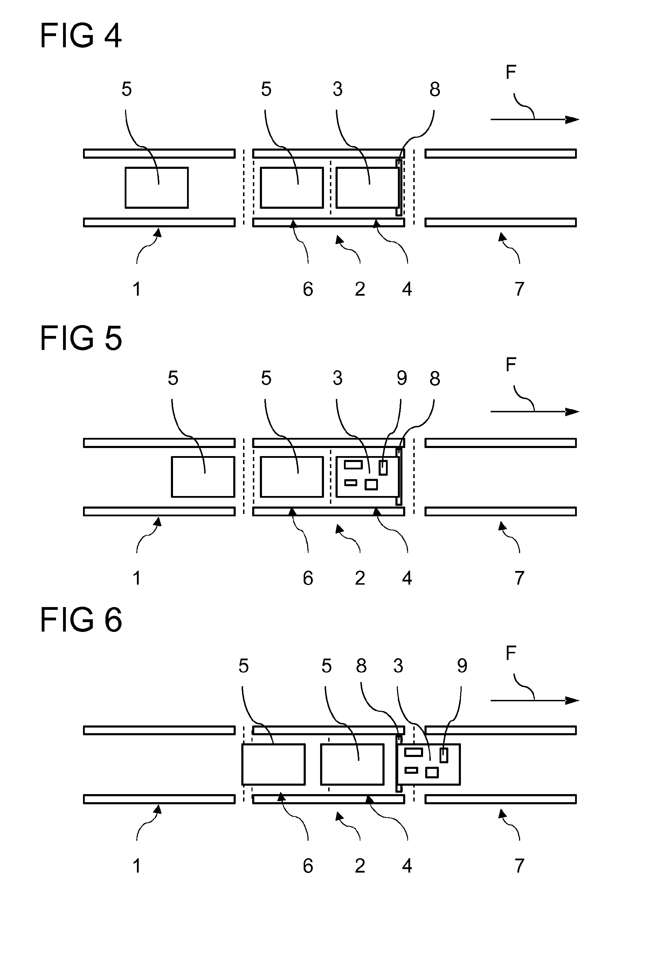

Der Ausschnitt des Transportsystems aus Fig. 3 ist in Fig. 4 zu einem zweiten Zeitpunkt dargestellt. Zu dem zweiten Zeitpunkt ist die erste Leiterplatte 3 an der Bestückungsstelle 4 angeordnet und zur Bestückung mittels einer Ausrichteinrichtung 8 positioniert sowie in dieser Lage an der Bestückungsmaschine temporär fixiert. Die Ausrichteinrichtung 8 ist als Sensor, z.B. als Lichtschranke, ausgebildet. Alternativ kann die Ausrichteinrichtung 8 z.B. als Endanschlag ausgebildet sein.

Die der ersten Leiterplatte 3 folgende zweite Leiterplatte 5 ist in dem Pufferbereich 6 angeordnet und ist vorzugsweise für den Weitertransport auf die Bestückungsstelle 4 ausgerichtet. Ebenfalls bevorzugt ist die zweite Leiterplatte 5 zu diesem Zeitpunkt an der Bestückungsmaschine temporär fixiert, um eine unbeabsichtigte Relativbewegung der zweiten Leiterplatte 5 zur Bestückungsmaschine zu verhindern. Des Weiteren ist eine weitere zweite Leiterplatten 5 in der Eingabesektion 1 angeordnet, die in Richtung Bestückungssektion 2 verfahren wird.

Der Ausschnitt des Transportsystems aus Fig. 3 ist in Fig. 5 zu einem dritten Zeitpunkt dargestellt. Zu dem dritten Zeitpunkt ist die erste Leiterplatte 3 mit Elektronikkomponenten 9 fertig bestückt und nicht mehr an der Bestückungsmaschine fixiert. Die Ausrichteinrichtung 8 ist derart verfahren bzw. verschwenkt, dass ein Weitertransport der bestückten ersten Leiterplatte 3 in die Ausgabesektion 7 durch die Ausrichteinrichtung 8 nicht mehr behindert wird. Die in der Eingabesektion 1 angeordnete zweite Leiterplatte 5 ist zu diesem Zeitpunkt der Bestückungsstation 2 benachbart angeordnet.

Der Ausschnitt des Transportsystems aus Fig. 3 ist in Fig. 6 zu einem vierten Zeitpunkt dargestellt. Zu dem vierten Zeitpunkt wird die erste Leiterplatte 3 von der Bestückungssektion 2 in die Ausgabesektion 7 und die folgende zweite Leiterplatte 5 von dem Pufferbereich 6 auf die Bestückungsstelle 4 gefahren. Vorzugsweise gleichzeitig wird die in der Eingabesektion 1 angeordnete zweite Leiterplatte 5 in den Pufferbereich 6 gefahren.

In dem dargestellten Beispiel weist der Pufferbereich 6 eine Größe auf, dass eine zweite Leiterplatte 5 in dem Pufferbereich 6 anordenbar ist. In alternativen Ausführungsvarianten des Verfahrens sind in dem Pufferbereich 6 zwei, drei oder mehr zweite Leiterplatten 5 anordenbar.

### Liste der Bezugszeichen und Symbole

- 1: Eingabesektion
- 2: Bestückungssektion
- 3: Erste Leiterplatte
- 4: Bestückungsstelle
- 5: Zweite Leiterplatte
- 6: Pufferbereich
- 7: Ausgabesektion
- 8: Ausrichteinrichtung
- 9: Elektronikkomponente

- 10: Erster Verfahrensschritt
- 20: Zweiter Verfahrensschritt
- 30: Dritter Verfahrensschritt
- 40: Vierter Verfahrensschritt
- 50: Fünfter Verfahrensschritt
- 60: Sechster Verfahrensschritt
- 70: Siebter Verfahrensschritt
- 80: Achter Verfahrensschritt

## Patentansprüche

1. Verfahren zum Bestücken von Leiterplatten auf einer Bestückungsmaschine, wobei die Leiterplatten eine erste Länge aufweisen, wobei die Bestückungsmaschine zum Bestücken von Leiterplatten einer zweiten Länge ausgebildet ist, wobei die zweite Länge mehr als doppelt so groß wie die erste Länge ist, wobei die Bestückungsmaschine eine Eingabesektion (1) und eine Bestückungssektion (2) aufweist, wobei die Bestückungssektion (2) in einer Förderrichtung (F) der Leiterplatten hinter der Eingabesektion (1) angeordnet ist, wobei die Leiterplatten der ersten Länge und die Leiterplatten der zweiten Länge in ihrer Längsrichtung von der Eingabesektion (1) in die Bestückungsstation transportierbar sind, aufweisend die nachfolgenden Verfahrensschritte:
- Transportieren einer ersten Leiterplatte (3) erster Länge aus der Eingabesektion (1) in die Bestückungssektion (2);
- Anordnen der ersten Leiterplatte (3) auf einer Bestückungsstelle (4) der Bestückungssektion (2);
- Transportieren mindestens einer zweiten Leiterplatte (5) erster Länge aus der Eingabesektion (1) in einen Pufferbereich (6) der Bestückungssektion (2), wobei der Pufferbereich (6) zwischen der Bestückungsstelle (4) und der Eingabesektion (1) angeordnet ist;
- lösbares Fixieren der ersten Leiterplatte (3) an der Bestückungsstelle (4);
- Bestücken der ersten Leiterplatte (3);
- Lösen der Fixierung der ersten Leiterplatte (3);
- Transportieren der ersten Leiterplatte (3) aus der Bestückungssektion (2) heraus; und
- Transportieren einer zweiten Leiterplatte (5), die der Bestückungsstelle (4) benachbart angeordnet ist, aus dem Pufferbereich (6) auf die Bestückungsstelle (4).

2. Verfahren gemäß Anspruch 1,
**dadurch gekennzeichnet,**
**dass** eine maximale Anzahl an in dem Pufferbereich (6) anordenbaren zweiten Leiterplatten (5) in Abhängigkeit der ersten Länge der zweiten Leiterplatten (5), einer Länge des Pufferbereichs (6) sowie einem festgelegten Abstand zwischen in dem Pufferbereich (6) benachbarten zweiten Leiterplatten (5) bestimmt, und dass nur so viele zweite Leiterplatten (5) in den Pufferbereich (6) transportiert werden, dass diese maximale Anzahl nicht überschritten wird.

3. Verfahren gemäß Anspruch 2,
**dadurch gekennzeichnet,**
**dass** eine Soll-Bestückungsleistung der Bestückungsmaschine sowie eine Anzahl an in den Pufferbereich (6) zu verfahrenden zweiten Leiterplatten (5) in Abhängigkeit der Soll-Bestückungsleistung der Bestückungsmaschine und der maximalen Anzahl an in dem Pufferbereich (6) anordenbaren zweiten Leiterplatten (5) bestimmt wird, und dass eine entsprechende Anzahl zweiter Leiterplatten (5) aus der Eingabesektion (1) in den Pufferbereich (6) der Bestückungssektion (2) transportiert wird.

4. Verfahren gemäß einem der vorangegangenen Ansprüche,
**dadurch gekennzeichnet,**
**dass** mindestens eine der zweiten Leiterplatten (5) in dem Pufferbereich (6) lösbar fixiert wird.

5. Verfahren gemäß einem der vorangegangenen Ansprüche,
**dadurch gekennzeichnet,**
**dass** mindestens eine in den Pufferbereich (6) transportierte zweite Leiterplatte (5) innerhalb des Pufferbereichs (6) vor dem Transportieren in die Bestückungsstelle (4) ausgerichtet wird.

6. Verfahren gemäß einem der vorangegangenen Ansprüche,
**dadurch gekennzeichnet,**
**dass** die Bestückungsstelle (4) an einem von der Eingabesektion (1) abgewandten Ende der Bestückungssektion (2) angeordnet ist.

7. Verfahren gemäß einem der vorangegangenen Ansprüche,
**dadurch gekennzeichnet,**
**dass** die bestückte erste Leiterplatte (3) aus der Bestückungssektion (2) in eine Ausgabesektion (7) transportiert wird.

8. Verfahren gemäß einem der vorangegangenen Ansprüche,
**dadurch gekennzeichnet,**
**dass** die zweiten Leiterplatten (5) im Pufferbereich (6) voneinander beabstandet angeordnet werden.

9. Verfahren gemäß einem der vorangegangenen Ansprüche,
**dadurch gekennzeichnet,**
**dass** eine Anwesenheit und/oder Lage der ersten Leiterplatte (3) und/oder mindestens einer zweiten Leiterplatte (5) in der Bestückungssektion (2) überwacht wird und bei Fehlen bzw. einer falschen Lage einer ersten Leiterplatte (3) und/oder zweiten Leiterplatte (5) eine entsprechende erste Leiterplatte (3) und/oder zweite Leiterplatte (5) in die entsprechende Stelle in der Bestückungsstation (2) transportiert bzw. die Lage der jeweiligen ersten Leiterplatte (3) und/oder zweiten Leiterplatte (5) korrigiert wird.

10. Verfahren gemäß einem der vorangegangenen Ansprüche,
**dadurch gekennzeichnet,**
**dass** beim Anordnen der ersten Leiterplatte (3) an der Bestückungsstelle (4) die erste Leiterplatte (3) in einen Wirkbereich mindestens eine Ausrichteinrichtung (8) gefördert wird.
